# EUROPEAN PATENT APPLICATION

(11) **EP 4 411 933 A1**
(43) Date of publication of application: **07.08.2024**
(21) Application number: 22875666.4
(22) Date of filing: 24.08.2022
(51) Int. Cl.: H01M 10/42, B60L 3/00, B60L 58/10, B61L 25/04, B61L 27/00, G16Y 10/40, G16Y 20/20, G16Y 40/20, H01M 10/48, H02J 7/00

(54) **ROLLING STOCK BATTERY MONITORING SYSTEM, ROLLING STOCK ONBOARD DEVICE, AND ROLLING STOCK BATTERY MONITORING METHOD**

(30) Priority: 28.09.2021 JP 2021157533
(71) Applicant: Hitachi, Ltd., Tokyo 100-8280 (JP)
(72) Inventor: TAKAHASHI, Chiaki, Tokyo 100-8280 (JP)
(74) Representative: MERH-IP Matias Erny Reichl Hoffmann Patentanwälte PartG mbB
(86) International application number: PCT/JP2022/031903
(87) International publication number: WO 2023/053794

(57) **Abstract**

According to the present invention, a battery monitoring system that monitors a plurality of storage batteries generates and records daily report data that is at least one of a maximum value, a minimum value, an average value, and an integrated value for battery characteristic values for all of the storage batteries for one day and transmits the daily report data to a ground server. The battery monitoring system also generates and records time series data for the battery characteristic values for a portion of the storage batteries for one day and transmits the time series data for the portion of the storage batteries to the ground server in conjunction with the daily report data for all of the storage batteries. Target storage batteries for which the time series data is acquired are switched every day. The target storage batteries that are switched every day are from series groups. The same number of target storage batteries that are switched every day are selected from all of the series groups. The battery characteristic values for the storage batteries represent one or more of current, voltage, temperature, and state of charge. The present invention thereby provides a rolling stock battery monitoring system that can reduce communication traffic for transmitting data needed for life estimation, predictive diagnosis, failure factor analysis, and the like from rolling stock to a ground server.

## Description

### Technical Field

The present invention relates to a rolling stock battery monitoring system, a rolling stock onboard device, and a rolling stock battery monitoring method.

### Background Art

Since a battery system mounted on a rolling stock is required to have a high voltage and a large capacity, a battery module is manufactured by combining a plurality of battery cells, and a plurality of the battery modules are connected in series and in parallel to form a battery system having a large capacity.

Usually, the battery system is provided with a battery monitoring system including a controller for appropriately managing a current and a temperature of a storage battery and using the storage battery safely, and in recent years, a method for monitoring a state of the battery system from a remote place using a mobile phone base station line such as LTE (3G Long Term Evolution) has been developed.

More specifically, a technique for transmitting time series data of a battery characteristic value of the storage battery to a ground server via the mobile phone base station line is known (For example, PTL 1). PTL 1 describes a method for transmitting a first battery characteristic value (for example, a current at the time of discharge) and a second battery characteristic value (for example, a voltage at the time of discharge) to the ground server, identifying a plurality of parameters from these data in the ground server, and restoring time series data, of the second battery characteristic value from the parameters and time series data of the first battery characteristic value. According to this, since the time series data of the second battery characteristic value can be deleted, data capacity can be expected to be reduced.

### Citation List

### Patent Literature

PTL 1: JP 2021-088249 A

### Summary of Invention

### Technical Problem

In the technique of PTL 1, by accumulating the time series data in the ground server, various operations such as life estimation, predictive diagnosis, factor analysis at the time of failure, and the like can be performed. Furthermore, according to this technique, it is possible to reduce the data capacity to be held by the ground server by enabling a part of the time series data to be restored from the plurality of parameters. However, in the technique of PTL 1, although the data capacity of the ground server can be reduced, a communication amount from the rolling stock to the ground server cannot be reduced. In addition, in general, a data size of the time series data is large, and since the mobile phone base station line such as LTE is used as a route for transmitting the time series data from the rolling stock to the ground server, an expensive communication fee is required.

The present invention has been made in view of the above problems, and an object of the present invention is to provide a rolling stock battery monitoring system capable of reducing a communication amount for transmitting data necessary for life estimation, predictive diagnosis, factor analysis at the time of failure, and the like from the rolling stock to the ground server.

### Solution to Problem

The present invention to solve the above problems is a rolling stock battery monitoring system that monitors a plurality of storage batteries, in which the system generates and records at least one of a maximum value, a minimum value, an average value, and an integrated value of battery characteristic values for one day in all storage batteries as daily report data, and transmits the daily report data to a server.

### Advantageous Effects of Invention

The present invention realizes the rolling stock battery monitoring system capable of reducing the communication amount for transmitting the data necessary for life estimation, predictive diagnosis, factor analysis at the time of failure, and the like from the rolling stock to the ground server. Problems, configurations, and effects other than those described above will be clarified by the following description of embodiments.

### Brief Description of Drawings

[FIG. 1] FIG. 1 is a block diagram illustrating a rolling stock battery monitoring system (hereinafter, also referred to as "the monitoring system") according to a first embodiment of the present invention, a ground server that cooperates with the battery monitoring system, and an overall configuration of a battery system to be monitored by the battery monitoring system and the ground server.
[FIG. 2] FIG. 2 is a block diagram illustrating a functional configuration of the monitoring system of FIG. 1.
[FIG. 3] FIG. 3 is a block diagram illustrating arithmetic processing of a daily report data generator in FIG. 2.
[FIG. 4] FIG. 4 is a table showing a list of output results of the daily report data generator in FIG. 2.
[FIG. 5] FIG. 5 is a block diagram illustrating arithmetic processing of a time series data generator in FIG. 2.
[FIG. 6] FIG. 6 is four types of graphs illustrating output results of the time series data generator in FIG. 2.
[FIG. 7] FIG. 7 is a block diagram illustrating a remote monitoring device in FIG. 2 in more detail.
[FIG. 8] FIG. 8 is a diagram illustrating selection of transmission data in a transmission data management part in FIG. 7 by an example.
[FIG. 9] FIG. 9 is a list diagram comparing daily report data and time series data accumulated in the ground server in FIG. 1.
[FIG. 10] FIG. 10 is a block diagram illustrating the arithmetic processing of the time series data generator according to a second embodiment of the present invention.
[FIG. 11] FIG. 11 is a circuit diagram illustrating storage batteries that are targets for which the time series data generator in FIG. 10 acquires data by connecting the storage batteries in series and parallel by an example.
[FIG. 12] FIG. 12 is a block diagram illustrating the arithmetic processing of the time series data generator according to a third embodiment of the present invention.
[FIG. 13] FIG. 13 is a circuit, diagram illustrating storage batteries that are targets for which the time series data generator in FIG. 12 acquires data by connecting the storage batteries in series and parallel by an example.
[FIG. 14] FIG. 14 is a diagram illustrating selection of the transmission data in the transmission data management part according to a fourth embodiment of the present invention by an example.
[FIG. 15] FIG. 15 is a diagram illustrating a functional configuration of the rolling stock battery monitoring system (this is also referred to as "the monitoring system") according to a fifth embodiment of the present invention.
[FIG. 16] FIG. 16 is a block diagram illustrating the remote monitoring device in FIG. 15 in more detail.
[FIG. 17] FIG. 17 is a diagram illustrating selection of the transmission data in the transmission data management part in FIG. 16 by an example.
[FIG. 18] FIG. 18 is a diagram illustrating accumulated data in the ground server in FIG. 16 by an example.

### Description of Embodiments

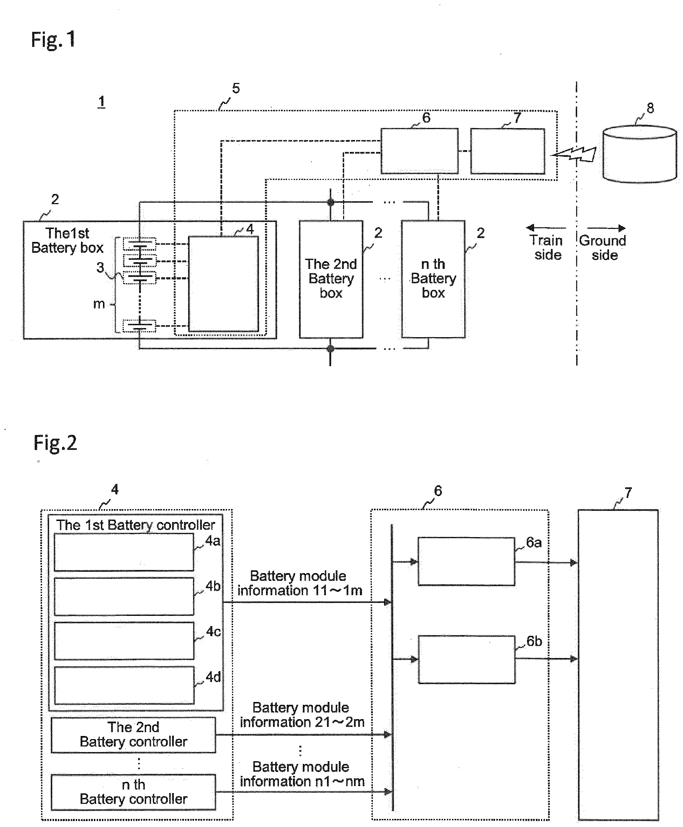

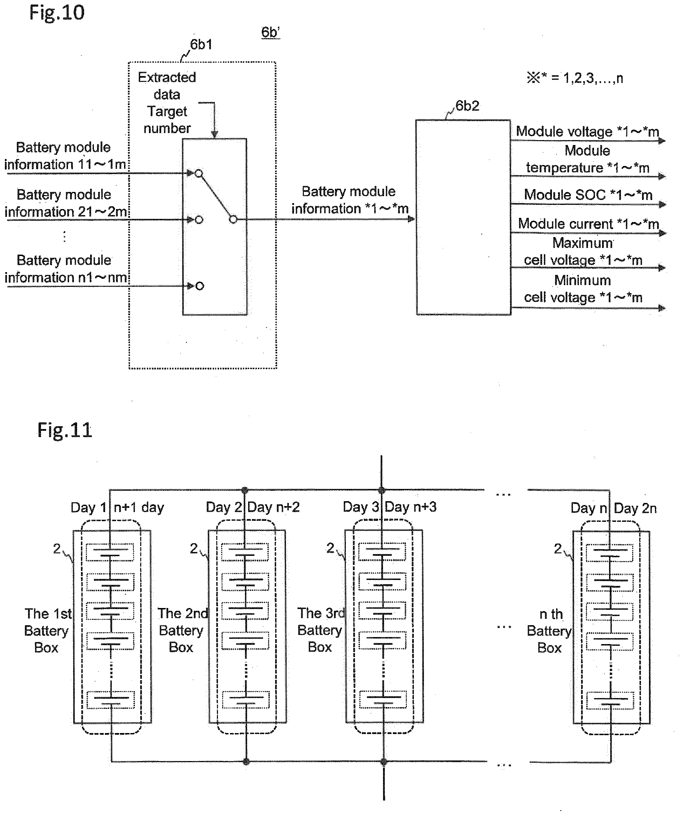

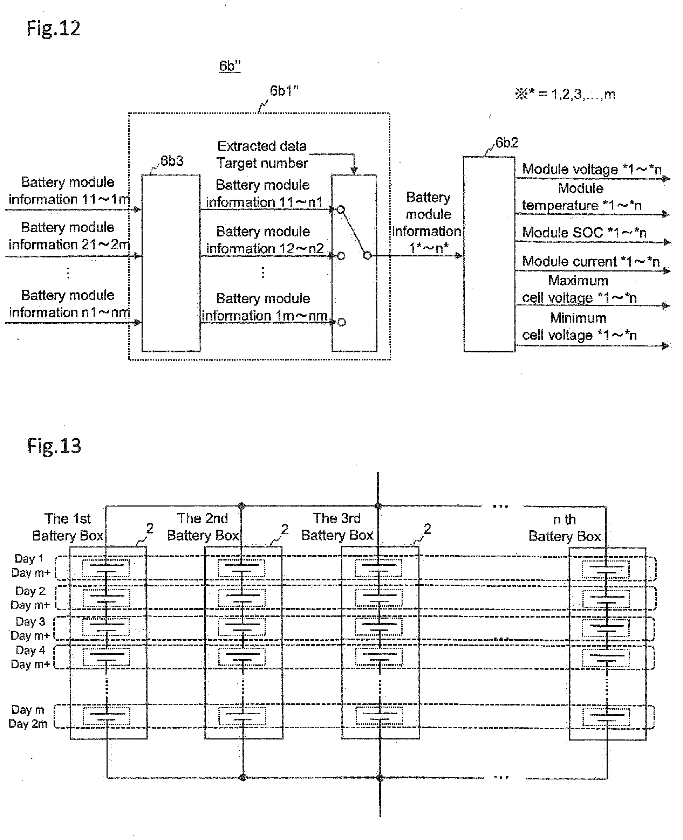

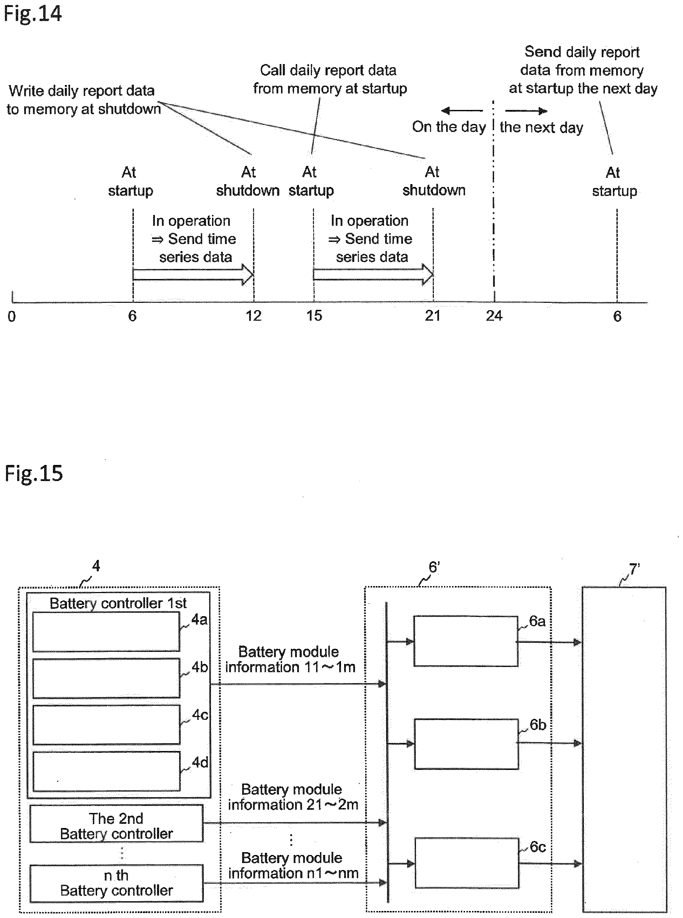

Hereinafter, the monitoring system will be described with reference to FIGS. 1 to 18. A first embodiment will be described with reference to FIGS. 1 to 9, a second embodiment will be described with reference to FIGS. 10 and 11, a third embodiment will be described with reference to FIGS. 12 and 13, a fourth embodiment will be described with reference to FIG. 14, and a fifth embodiment will be described with reference to FIGS. 15 to 18. Note that, as will be described later with reference to FIG. 1, the monitoring system 5 is an information processing function for remotely monitoring a battery state of a battery system 1 mounted on a rolling stock mainly on a ground, and is configured to be able to cooperate with not only a rolling stock onboard device (hereinafter, also referred to as "the present onboard device") but also a rolling stock ground facility.

### First embodiment

Hereinafter, the first embodiment will be described with reference to FIGS. 1 to 9. FIG. 1 is a block diagram illustrating.the monitoring system 5, a ground server 8 that cooperates with the monitoring system 5, and an overall configuration of the battery system 1 to be monitored by the monitoring system 5 and the ground server 8. As illustrated in FIG. 1, remote monitoring of storage batteries mounted on the rolling stock is realized by the battery system 1 as the onboard device and the ground server 8 as the rolling stock ground facility. the monitoring system 5 for this purpose is mainly configured to include a battery controller 4 as the onboard device, an upper controller 6, and a remote monitoring device 7 surrounded by a broken line in FIG. 1, and operates in cooperation with the ground server 8. Further, the ground server 8 may also be considered to be included in the monitoring system 5. Note that the rolling stock battery monitoring method performed using the monitoring system 5 is also referred to as the present method.

The battery system 1 is configured to include a plurality of storage battery boxes 2 including first to nth storage battery boxes, the upper controller 6, and the remote monitoring device 7. The storage battery box 2 is a housing that stores a battery module 3 and the battery controller 4, and is outfitted on a roof or under a floor of the rolling stock (not illustrated) . Further, in the first embodiment, the storage battery boxes 2 are the plurality of storage battery boxes 1 to n, but a plurality of series group circuits may be stored in one box. Note that how many battery cells the battery module 3 includes is arbitrary.

In the battery module 3, a plurality of battery cells, which are minimum units of a storage battery, are connected in combination, and a monitoring board (not illustrated) for a battery cell voltage and a thermistor (not illustrated) for temperature detection are attached. Note that as shown surrounded by broken lines in FIGS. 11 and 13 and described later, the voltage is based on the premise that all the battery cells are individually and simultaneously monitored across the plurality of storage battery boxes 2. The battery controller 4 calculates a degradation level such as a capacity retention rate and a resistance increase rate, in other words, an index value representing a life, in-addition to a charging rate (SOC: state of charge) of the storage battery. Note that, capacity retention ratio = battery capacity in a certain cycle/initial battery capacity×100, and an amount of decrease in capacity retention ratio and the resistance increase rate are positively correlated with each other.

These index values such as SOC are calculated based on, for example, the voltage and temperature of the battery module 3, and a current for each series group for each battery box 2. The voltage and temperature of the battery module 3 are measured by a sensor mounted on the battery module 3. The current for each series group is measured by a current sensor attached for each series group. Here, the battery controller 4 is disposed in correspondence with m battery modules 3 connected in series, and collectively detects the voltage, the current, and the temperature, but detects only the voltage individually for each battery cell. That is, in the battery controller 4, the current and the temperature are monitored for each battery module, that is, for each battery box 2, and the voltage is monitored for every battery cell. Note that the present invention is not limited to such a configuration, and can also be applied to other forms.

The upper controller 6 receives all the current, the voltage, the temperature, the SOC, and the degradation level (life) output for each battery controller 4. Data processing in the upper controller 6 will be described later. The remote monitoring device 7 includes a router (not illustrated) and an antenna (not illustrated) that perform communication using a mobile phone base station line such as LTE, 4G, or 5G, and transmits data processed by the upper controller 6 to the ground server 8 . The ground server 8 receives and accumulates the data transmitted by the remote monitoring device 7.

FIG. 2 is a block diagram illustrating a functional configuration of the monitoring system 5' of FIG. 1. As illustrated in FIG. 2, the battery controller 4 includes a battery characteristic value measuring part 4a, an SOC estimation part 4b, an abnormality diagnosis part 4c, and a cell information processing part 4d. The battery characteristic value measuring part 4a measures each battery cell voltage in addition to a battery module voltage, a battery module current, and a battery module temperature. The SOC estimation 4b estimates a battery module SOC based on the battery module voltage, the battery module current, and the battery module temperature among the measured battery characteristics.

The abnormality diagnosis part 4c performs failure diagnosis of overvoltage, overcurrent, overtemperature, or the like, changes and displays a battery module failure flag from 0 (no failure) to 1 (with failure) when a failure occurs, and sets a battery module failure code from 00 (no failure) to a value assigned to each failure item. The cell information processing part 4d outputs the maximum value as the maximum battery cell voltage and the minimum value as the minimum battery cell voltage among the battery cell voltages in the battery module 3.

As described above, the battery controller 4 acquires the battery module voltage, the battery module current, the battery module temperature, the battery module SOC, the battery module failure flag, the battery module failure code, the maximum battery cell voltage, and the minimum battery cell voltage, and transmits these pieces of information to the upper controller 6 as battery module information.

The upper controller 6 receives battery module information nm from each of a plurality of the battery controllers 4. A reference sign nm attached to the information specifies a position of the battery module. For example, battery module information 21 indicates information on a battery module of a first stage from a high (positive) voltage side housed in a second (FIGS. 1, 11, and 13) battery box 2, that is, in a second series group in the battery system 1.

The battery module information nm is input to a daily report data generator 6a and a time series data generator 6b in the upper controller 6. The daily report data generator 6a and the time series data generator 6b record daily report data and time series data generated separately and transmit the same to the remote monitoring device 7. Such a monitoring system 5 can reduce a communication amount for transmitting data necessary for life estimation, predictive diagnosis, factor analysis at the time of failure, and the like from the rolling stock to the ground server 8. The reason will be described below.

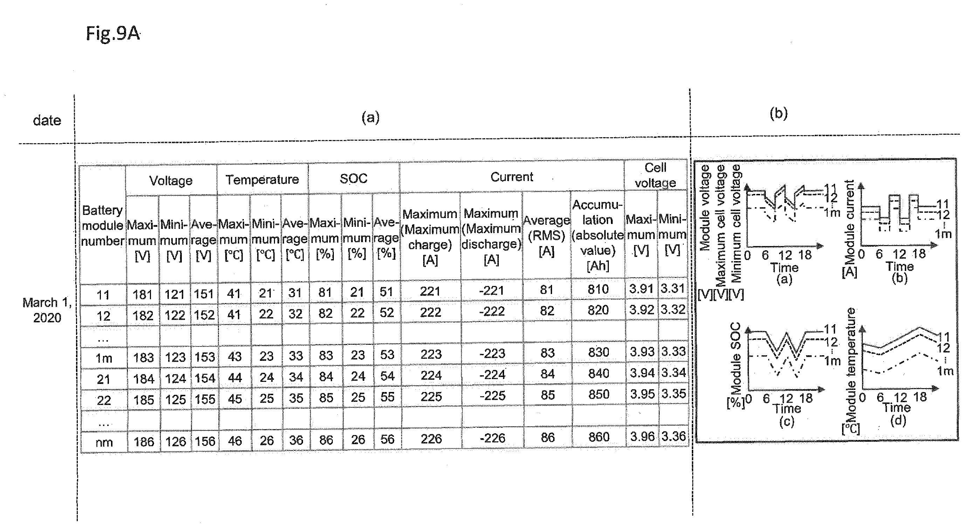

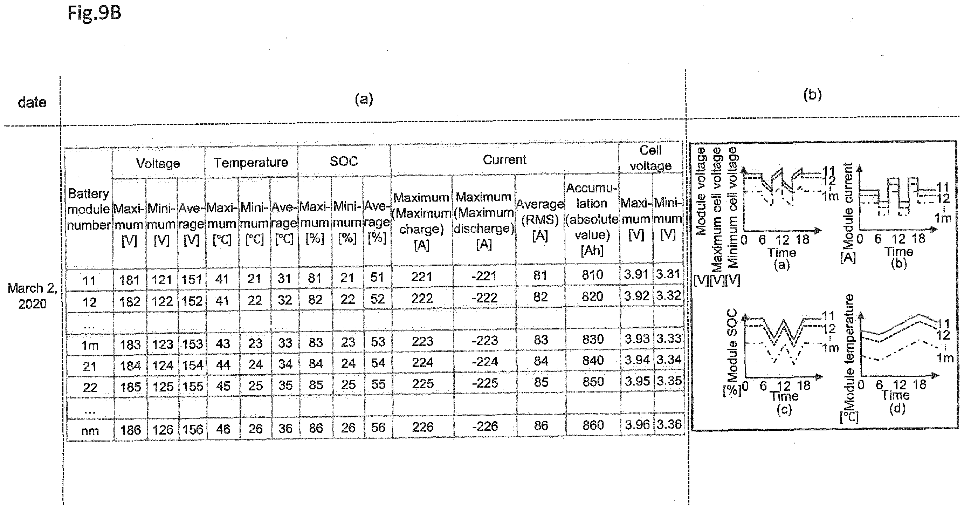

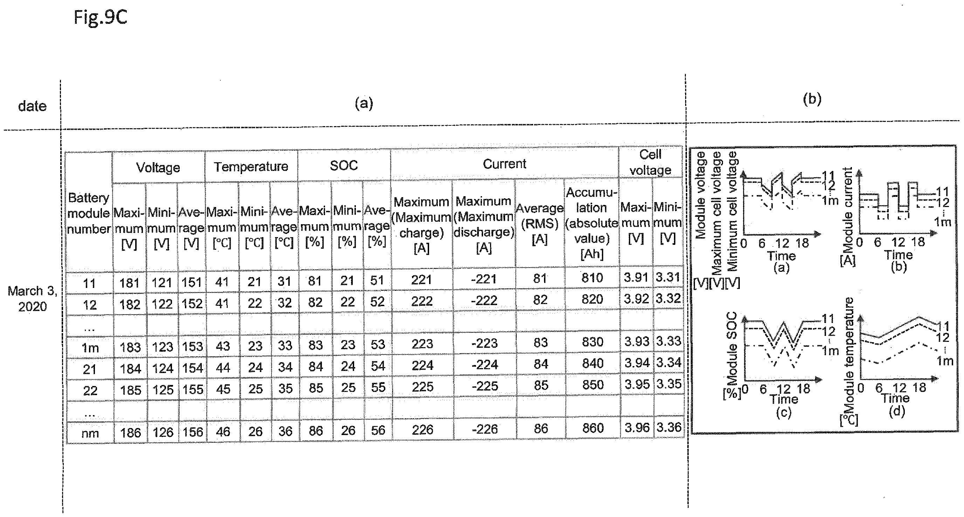

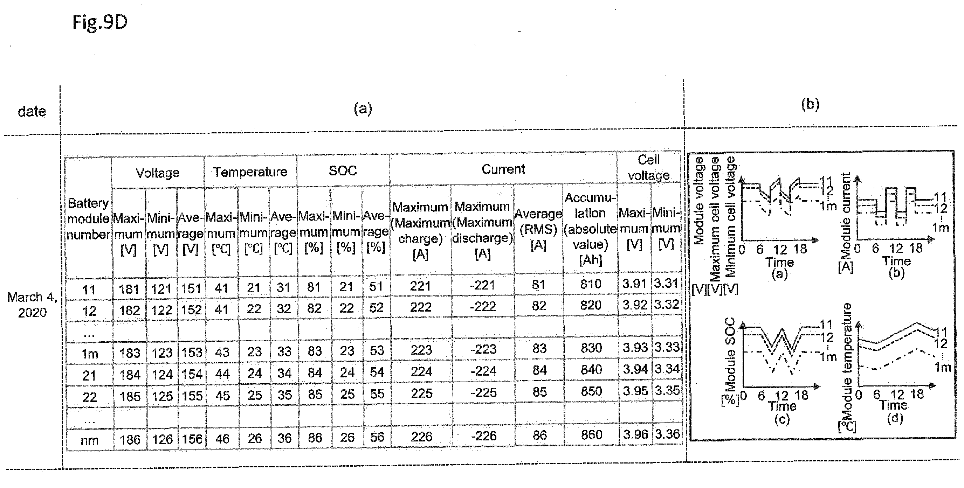

The time series data is a huge amount of information, and when the failure occurs, data at the optimum timing is provided in an easily analyzable state for investigating a cause of the failure, but the communication is considerably burdened. In contrast, regarding the daily report data, as will be described later using a comparison list in FIG. 9, only remarkable characteristic data among a huge amount of time series data can be shown with a small amount of information.

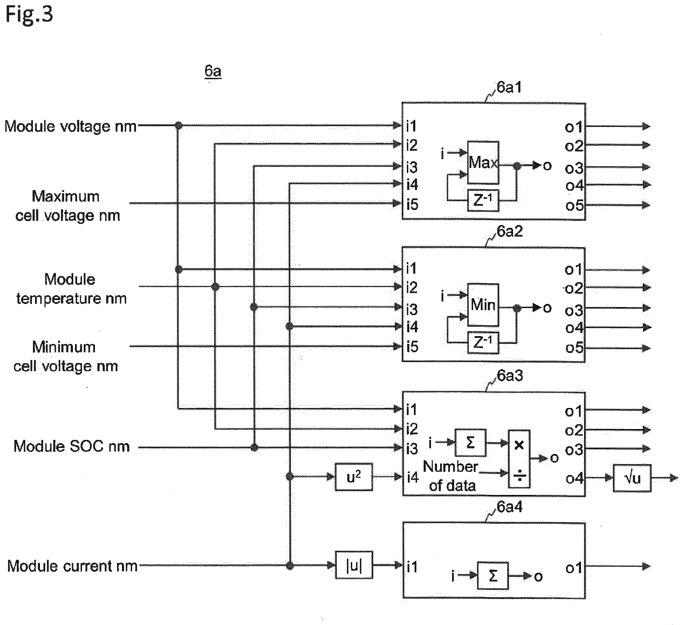

FIG. 3 is a block diagram illustrating arithmetic processing of the daily report data generator 6a in FIG. 2. As illustrated in FIG. 3, the daily report data generator 6a receives six inputs of a battery module voltage nm, a maximum battery cell voltage nm, a battery module temperature nm, a minimum battery cell voltage nm, a battery module SOC nm, and a battery module current nm, and calculates at least one of a maximum value, a minimum value, an average value, and an integrated value for each of these characteristic values. Note that the reference sign nm specifies any of the plurality of battery cells arranged to be connected in series and in parallel.

A maximum value calculator 6a1 receives five inputs of the battery module voltage nm, the battery module temperature nm, the battery module SOC nm, the battery module current nm, and the maximum battery cell voltage nm, and extracts a larger value by comparing an input in a current measurement cycle with a maximum value of an output one cycle before for each input, to constantly output a maximum value during operation.

A minimum value calculator 6a2 receives inputs of, the battery module voltage nm, the battery module temperature nm, the battery module SOC nm, the battery module current nm, and the minimum battery cell voltage nm, and extracts a smaller value by comparing the input in the current measurement cycle with a minimum value of the output one cycle before for each input, to constantly output a minimum value during operation.

An average value calculator 6a3 calculates a sum of each of the battery module voltage nm, the battery module temperature nm, and the battery module SOC nm, and outputs an average value obtained by dividing the sum by the number of pieces of data. Further, regarding the battery module current nm, a squared value is input to the average value calculator 6a3, and a square root of the output is calculated to output a Root Mean Square (RMS) value. Finally, an integrated value calculator 6a4 inputs an absolute value of the battery module current nm, calculates the sum, and outputs the sum as the integrated value of the battery module current nm.

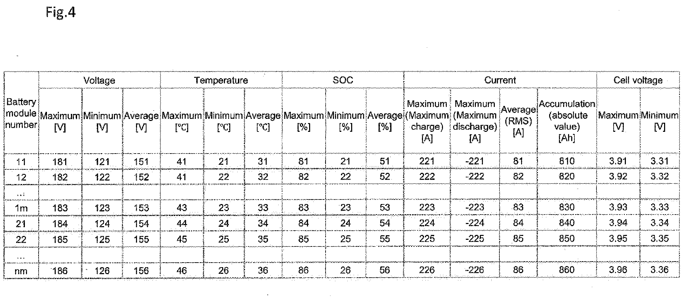

FIG. 4 is a table showing a list of output results of the daily report data generator 6a in FIG. 2. As illustrated in FIG. 4, it is indicated that a representative value of battery characteristic values, that is, at least one of the maximum value, the minimum value, the average value, and the integrated value is calculated for all numbers 11 to nm of the battery modules 3.

Note that in the daily report data, for example, some characteristic values may be omitted, such as an integrated voltage value not shown in the table of FIG. 4. Further, as an ordinary means of statistical processing, calculation' processing such as square and square root may be performed before and after processing of calculating at least one of the maximum value, the minimum value, the average value, and the integrated value, like an RMS current value in the daily report data.

As described above, the monitoring system 5 records and outputs at least one of the maximum value, the minimum value, the average value, and the integrated value of the battery characteristic values as the daily report data, thereby reducing an amount of data as compared with the time series data. Thus, the monitoring system 5 compares daily report data on day after day and captures a change in state as characteristic information. That is, when the monitoring system 5 is used to grasp only a noticeable change, it is convenient to thin out and omit time series data having no change from daily comparison data because the characteristic information is highlighted.

Further, since operation of the rolling stock is managed on a daily basis, if the monitoring system 5 is for railway use, comparison of differences between operation numbers and influence on the storage battery when an unsteady state such as an accident occurs can be easily visualized by using simpler daily report data. That is, the monitoring system 5 makes it easy to visually recognize and capture unusual characteristic information by graphing the daily report data.

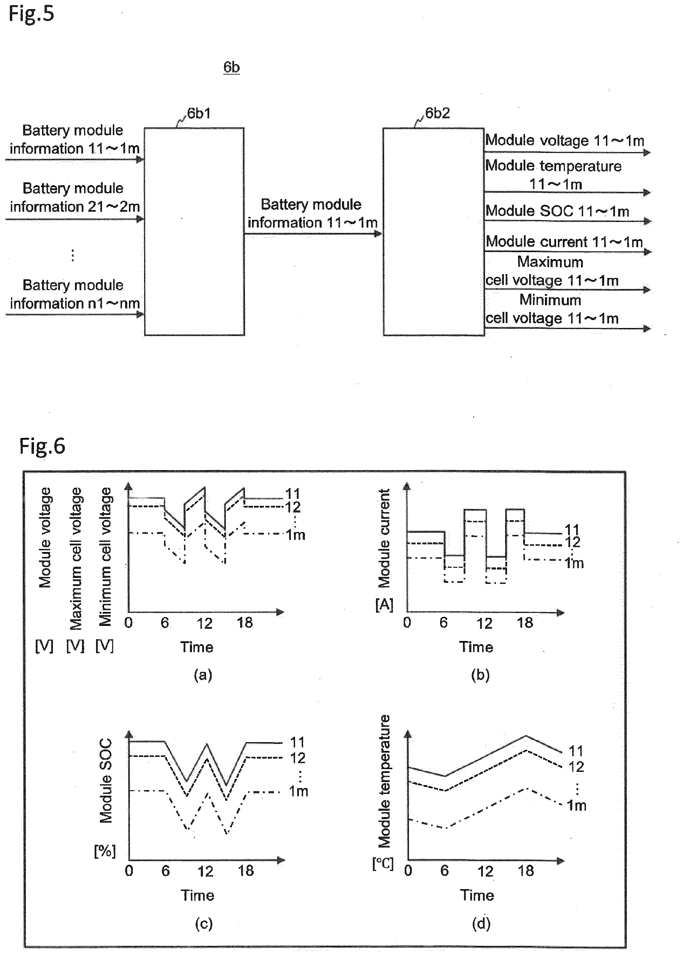

FIG. 5 is a block diagram illustrating arithmetic processing of the time series data generator 6b in FIG. 2. As illustrated in FIG. 5, the time series data generator 6b includes a time series data target extraction part 6b1 and a battery characteristic value data extraction part 6b2. First, the time series data target extraction part 6b1 extracts target data to be sent to the ground server 8 by the remote monitoring device 7 among the characteristic information on all the battery modules 3.

Note that in the first embodiment, as illustrated in FIG. 5, the battery module information 11 to 1m of a first series group among the battery module information 11 to nm of all the battery modules 3 was extracted as extracted data as a monitoring target transmitted to the ground server 8 by the monitoring system 5. This is merely an example, and a data extraction target for the battery module information may be changed. Further, the monitoring system 5 may set one battery module or may set two or more series groups as a data extraction source of the battery module information, that is, the monitoring target. Various aspects of such selection of the monitoring target will be described later with reference to FIGS. 10 and 11 of the second embodiment and FIGS. 12 and 13 of the third embodiment.

Next, the battery characteristic value data extraction part 6b2 further extracts, as the battery characteristic values, battery module voltages 11 to 1m, battery module temperatures 11 to 1m, battery module SOCs 11 to 1m, battery module currents 11 to 1m, maximum battery cell voltages 11 to 1m, and minimum voltages 11 to 1m from the battery module information 11 to 1m extracted by the time series data target extraction part 6b1, and records and outputs them.

FIG. 6 is four types of graphs illustrating output results of the time series data generator 6b in FIG. 2. In FIG. 6, the horizontal axis represents time, and the vertical axis plots the battery characteristic values distinguished by the following graphs (a) to (d) . In each graph, the characteristic values classified into (a) the battery module voltage, the maximum battery cell voltage, and the minimum battery cell voltage, (b) the battery module current, (c) the battery module SOC, and (d) the battery module temperature are plotted. By obtaining such time series data, the monitoring system 5 can perform the life estimation, the factor analysis at the time of failure, and the like for the storage battery (the box, the battery module, or the battery cell) to be monitored. Note that description of an analysis method therefor will be omitted.

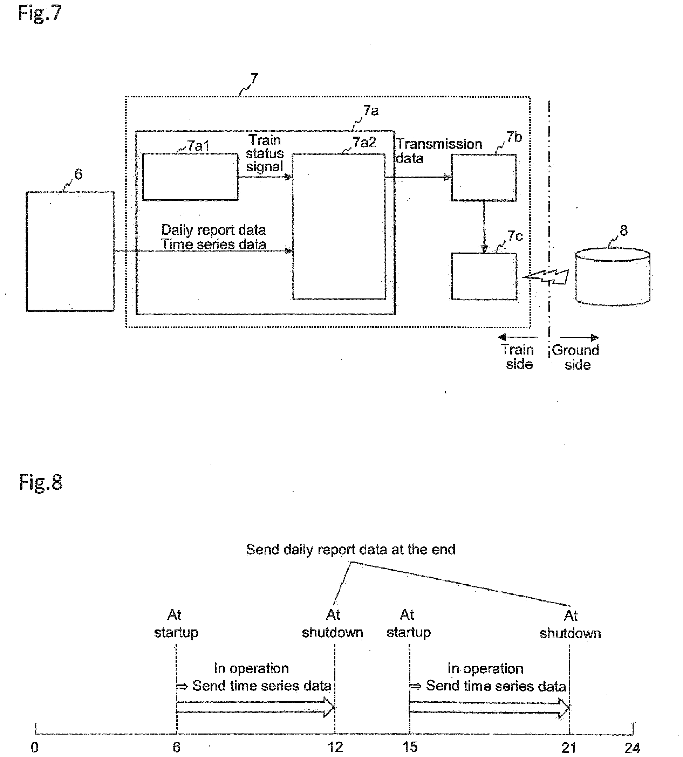

FIG. 7 is a block diagram illustrating the remote monitoring device 7 in FIG. 2 in more detail. As illustrated in FIG. 7, the remote monitoring device 7 includes an on-board server 7a, a router 7b, and an antenna 7c. First, the on-board server 7a will be described. A more specific example of the on-board server 7a is one that stores the time series data for a certain period in a memory card provided in a part of a train cab and transmits the time series data to the ground server 8 as appropriate.

The on-board server 7a has functions of a start/end judgment part 7a1 and a transmission data management part 7a2. The start/end judgment part 7a1 determines whether the rolling stock is at the start, in operation, or at the end, and transmits a determination result as a rolling stock status signal to the transmission data management part 7a2. Next, the transmission data management part 7a2 determines transmission data to be transmitted to the ground server 8 on the basis of the daily report data, the time series data, and the rolling stock status signal received from the upper controller 6.

FIG. 8 is a diagram illustrating selection of the transmission data in the transmission data management part 7a2 in FIG. 7 by an example. As illustrated in FIG. 8, when a normal rolling stock is started in the morning, a power supply of the rolling stock is not turned off until the end of operation on that day in many cases, but the power supply may be turned off halfway due to a power failure, a long-time suspension, or the like, and thus it is assumed that the start and end (shutdown) of a computer occur twice in a day.

In the first embodiment, the transmission data management part 7a2 sets the time series data of the battery characteristic values as the transmission data during operation, and sets the daily report data as the transmission data at the end when a driver turns off the power supply. Then, the transmission data including the daily report data of all the storage batteries and the time series data of some of the storage batteries are transmitted to the ground server 8 through the router 7b and the antenna 7c.

The ground server 8 receives the time series data during operation and the daily report data at the end, and accumulates these data for data display and data analysis. Here, when the ground server 8 receives the daily report data multiple times in one day, the ground server 8 creates the daily report data for the day from each daily report data and each operating time.

Further, in FIG. 8, the operating time is from 6:00 to 12:00 and from 15:00 to 21:00, but some routes operate even after 24: 00. In this case, for example, a time at which the operation is normally considered to be ended, such as 3:00 AM, may be set as an end of the day.

FIG. 9 is a list diagram comparing the daily report data and the time series data accumulated in the ground server 8 in FIG. 1. As illustrated in FIG. 9, (a) the daily report data of all the battery modules and (b) the time series data of some battery modules (the battery modules 11 to 1m) are accumulated for each year/month/date.

First, as illustrated in FIG. 9(b), the ground server 8 accumulates the time series data of, for example, three arbitrarily specified battery modules 11, 12, and 1m although partially. A manager of the storage battery can grasp a secular change in behavior of the battery characteristic values, a change in the battery characteristic values due to a travel route and a temperature change, and the like on the basis of the time series data stored in this way. Therefore, the manager of the storage battery can utilize the stored time series data for life estimation, the predictive diagnosis, and the factor analysis at the time of failure.

Further, as illustrated in FIG. 9(a), the ground server 8 includes a program for analysis, and executes the program to specify, in each battery module nm in the battery system 1, any one of nm if there is a battery module having an unusual difference from an overall average, in addition to individual variations. In this manner, the ground server 8 can grasp states of all or some arbitrarily specified battery modules nm in the battery system 1 to be monitored.

Furthermore, when degradation or temperature variation of the battery system 1 to be monitored is small, the ground server 8 combines two in FIGS. 9 (a) and 9(b) to correct the time series data in FIG. 9 (b) based on the daily report data in FIG. 9(a), so that it is possible to analogize even the time series data of the battery module not to be monitored in FIG. 9(b). As a result, the monitoring system 5 can grasp an overall state of the battery modules 3 in the battery system 1 in the manner of a sampling inspection.

In order to obtain the same effect as described above, the time series data of all the battery modules 3 may be transmitted from the remote monitoring device 7 to the ground server 8. However, the amount of information in such a case is enormous, and the communication is burdened. In contrast, regarding the daily report data, only the remarkable characteristic data among the huge amount of time series data can be shown with a small amount of information. Therefore, in the first embodiment, when the daily report data is transmitted for all the storage batteries and the time series data is transmitted for some of the storage batteries, the communication amount from the rolling stock to the ground server 8 can be reduced.

### Second embodiment

In the battery monitoring system 5 of the first embodiment, there is no idea of actively switching and selecting the plurality of battery modules 3 to be monitored. Respective aspects of the second embodiment and the third embodiment different from the first embodiment in this point will be sequentially described. First, the second embodiment will be described with reference to FIGS. 10 and 11. In the rolling stock battery monitoring system 5 according to the second embodiment (reference numeral 5 in FIG. 1 is referred to), a storage battery from which the time series data is to be acquired is not fixed but is switched every day. FIG. 10 is a block diagram illustrating the arithmetic processing of the time series data generator 6b' according to the second embodiment of the present invention.

In the first embodiment, the battery modules from which the time series data is to be acquired are always the first series group (the battery modules 11 to 1m), but in the second embodiment, a switch is provided in a time series data target extraction part 6b1', and the target is switched based on an extracted data target number. The extracted data target number is incremented, for example, every day, and is set to return to 1 on the next day when the maximum number of the series groups is reached.

FIG. 11 is a circuit, diagram illustrating the storage batteries that are targets for which the time series data generator 6b' in FIG. 10 acquires the data by connecting the storage batteries in series and parallel by an example. As illustrated in FIGS. 10 and 11, the time series data generator 6b' of the second embodiment switches the series groups of the batteries that is a data acquisition target every day. The time series data generator 6b' is configured to set, as the data acquisition target, the battery modules 11 to 1m in a first storage battery box 2 on a first day, the battery module 22 to 2m in a second storage battery box 2 on a second day, and the battery module 11 to 1m in the first storage battery box 2 again on the next day when the data of the battery modules n1 to nm in the nth storage battery box 2 that is the last storage battery box 2 on the nth day are acquired.

With the above configuration, the monitoring system 5 of the second embodiment can periodically acquire the time series data of all the battery modules. Therefore, it is possible to analyze the secular change of the battery characteristic values of all the battery modules in the battery system 1. Further, the monitoring system 5 of the second embodiment can grasp variation in the battery cell voltage between the battery cells having the same current in the same series group by setting the data acquisition target for each series group. As a result, the monitoring system 5 of the second embodiment is particularly useful for preventing a failure such as battery cell overvoltage in advance. Note that as for the voltage, all the battery cells are individually monitored.

Further, in the monitoring system 5 of the second embodiment, an opportunity to acquire the time series data is, for example, once every 12 days in the case of a 12-parallel battery system-1. With respect to this cycle, it is conceivable that a change such as battery deterioration or seasonal variation changes in a sufficiently longer cycle than this. Therefore, in the monitoring system 5 of the second embodiment, the opportunity to acquire the time series data may be a frequency of once in a plurality of days. Other configurations of the second embodiment are the same as those of the first embodiment described above, and redundant descriptions are omitted. As illustrated by boxes surrounded by the broken lines in FIG. 11, any one of the battery cells can be individually or simultaneously monitored across the plurality of storage battery boxes 2. Note that range, information density, and frequency of the monitoring target can be arbitrarily set, and the boxes surrounded by the broken lines illustrated in FIG. 11 are merely an example.

### Third embodiment

Next, the rolling stock battery monitoring system 5 (corresponding to 5 in FIG. 1 and to FIG. 2) according to the third embodiment will be described with reference to FIGS. 12 and 13. In the monitoring system 5 according to the third embodiment, target storage batteries from which the time series data is to be acquired by being switched every day are not set for each series group, but the same number of battery modules are selected as the monitoring target from all the first to nth series groups. FIG. 12 is a block diagram illustrating the arithmetic processing of a time series data generator 6b" according to the third embodiment of the present invention.

The time series data generator 6b" according to the third embodiment in FIG. 12 is different from the time series data generator 6b' according to the second embodiment in FIG. 10 in that a battery module information rearrangement part 6b3 is added at a preceding stage of the switch. The battery module information rearrangement part 6b3 disassembles and reconstructs the battery module information *1 to *m (* = 1, 2, 3, ..., n) transmitted from each battery controller 4, to generate the battery module information 1* to n* (* = 1, 2, 3, ..., m) .

FIG. 13 is a circuit diagram illustrating the storage batteries that are targets for which the time series data generator 6b" in FIG. 12 acquires the data by connecting the storage batteries in series and parallel by an example. As illustrated in FIG. 13, in the third embodiment, the same number of battery modules are selected from each series group, such as a first battery module from a high voltage side of all the series groups on the first day and a second battery module from the high voltage side of all the series groups on the second day.

With the above configuration, the third embodiment can periodically acquire the time series data of all the battery modules. Furthermore, by selecting the data acquisition target for each of all the series groups, it is possible to grasp current variation between the series groups, which is useful for preventing the failure such as overcurrent in advance. Other configurations of the third embodiment are the same as those of the first embodiment and the second embodiment described above, and redundant descriptions are omitted. Further, as illustrated by boxes surrounded by the broken lines in FIG. 13, any one of the battery modules can be individually or simultaneously monitored across the plurality of storage battery boxes 2. Note that the range, the information density, and the frequency of the monitoring target can be arbitrarily set, and the boxes surrounded by the broken lines illustrated in FIG. 13 are merely an example.

### Fourth embodiment

Next, the fourth embodiment will be described with reference to FIG. 14. FIG. 14 is a diagram illustrating selection of the transmission data in the transmission data management part (corresponding-to 7a2 in FIG. 7) according to the fourth embodiment of the present invention by an example. In the first embodiment illustrated in FIG. 8, daily report data transmission timing from the remote monitoring device 7 to the ground server 8 is set at the end of each operation (shutdown of the computer) . In contrast, in the fourth embodiment in FIG. 14, the timing is set at the time of start on the next day.

In the rolling stock battery monitoring system 5 (corresponding to 5 in FIG. 1 and to FIG. 2) according to the fourth embodiment, the on-board server 7a includes a nonvolatile memory. Then, the daily report data is written in the nonvolatile memory at the end of operation, and the daily report data is called from the nonvolatile memory and operated at the next start. Then, at the time of first start on the next day (next operation day), the daily report data is called from the nonvolatile memory and transmitted to the ground server 8 through the router 7b and the antenna 7c.

With the above configuration, the monitoring system 5 of the fourth embodiment can set the number of times of transmission of the daily report data to one even when the operation is started and ended a plurality of times in one day, and can reduce the communication amount as compared with the case of the first embodiment. In the monitoring system 5 according to the fourth embodiment, when a plurality of times of daily report data exists with different contents in one day, for example, each of the maximum value and the minimum value is collected into a single daily report data by extracting only a more remarkable one. Therefore, the monitoring system 5 of the fourth embodiment does not worry about which daily report data is to be transmitted among the plurality of times of daily report data with different contents.

### Fifth embodiment

Next, the fifth embodiment will be described with reference to FIGS. 15 to 18. In the rolling stock battery monitoring system 5 (corresponding to 5 in FIG. 1 and to FIG. 2) according to the fifth embodiment, the time series data of some storage batteries during the entire operating time is not transmitted to the ground server 8, but the time series data of the storage batteries is transmitted to the ground server 8 only for several minutes before and after the failure occurs .

FIG. 15 is a block diagram illustrating a functional configuration of the battery monitoring system 5. As illustrated in FIG. 15, in the monitoring system 5 of the fifth embodiment, an event data generator 6c is added as a function of an upper controller 6'.

The event data generator 6c generates and outputs a failure occurrence flag obtained by selecting battery module failure flags of all the battery modules 3 by OR logic. Further, in the monitoring system 5 of the fifth embodiment, a daily report data creator 6a' records a time (failure occurrence time) when the battery module failure flag becomes 1 (with failure) and a failure code on the basis of the battery module failure flag of each battery module 3. Furthermore, although processing is the same as that of the first embodiment, the time series data generator 6b outputs the time series data of the battery characteristic values of all the battery modules 3 for a predetermined time before and after the accident occurs.

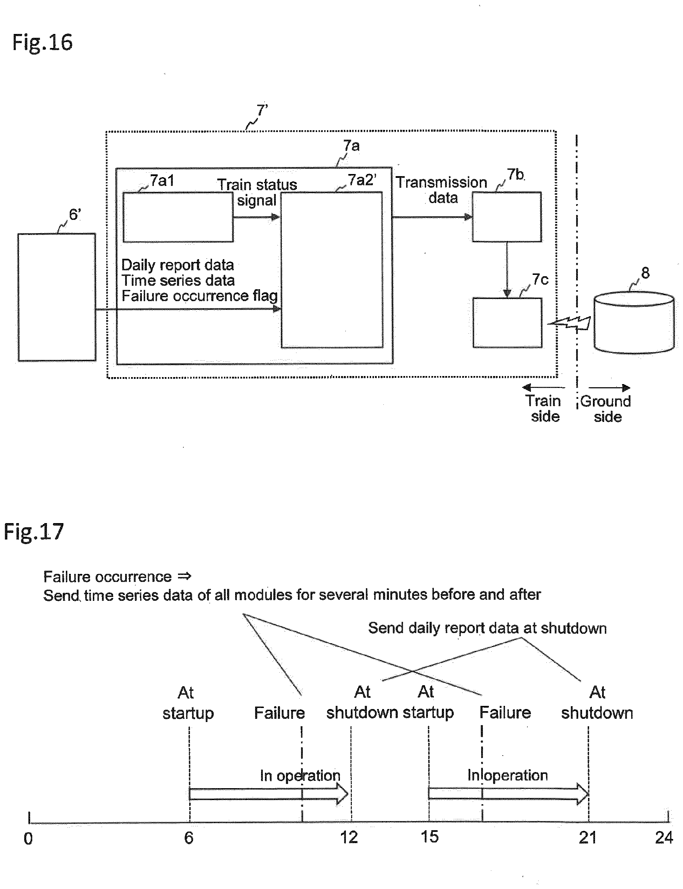

FIG. 16 is a block diagram illustrating the remote monitoring device 7 in FIG. 15 in more detail. As illustrated in FIG. 16, in the fifth embodiment, processing of a transmission data management part 7a2' in an on-board server 7a' is different. The transmission data management part 7a2' holds the time series data for the past several minutes over all the storage batteries received from the upper controller 6', and sets the time series data for several minutes before and after the accident in which the failure occurrence flag becomes 1 (with failure) as the transmission data.

FIG. 17 is a diagram illustrating selection of the transmission data in the transmission data management part 7a2' in FIG. 16 by an example. As illustrated in FIG. 17, for two times of failure occurrence during operation, the time series data of all the battery modules for several minutes before and after each time is transmitted to the ground server 8 as the transmission data. In addition, the daily report data is transmitted to the ground server 8 at the end as in the first embodiment. Since a total amount of time series data for one day is enormous, only main points for several minutes before and after the accident are used as the time series data.

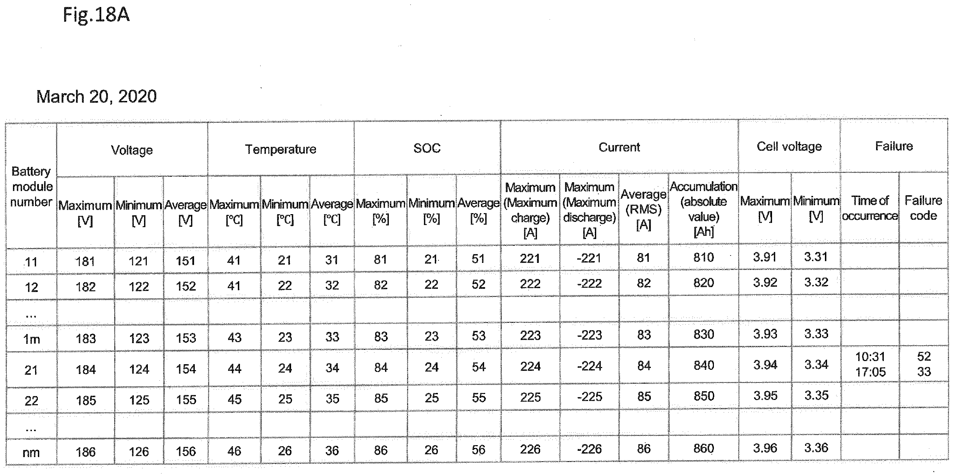

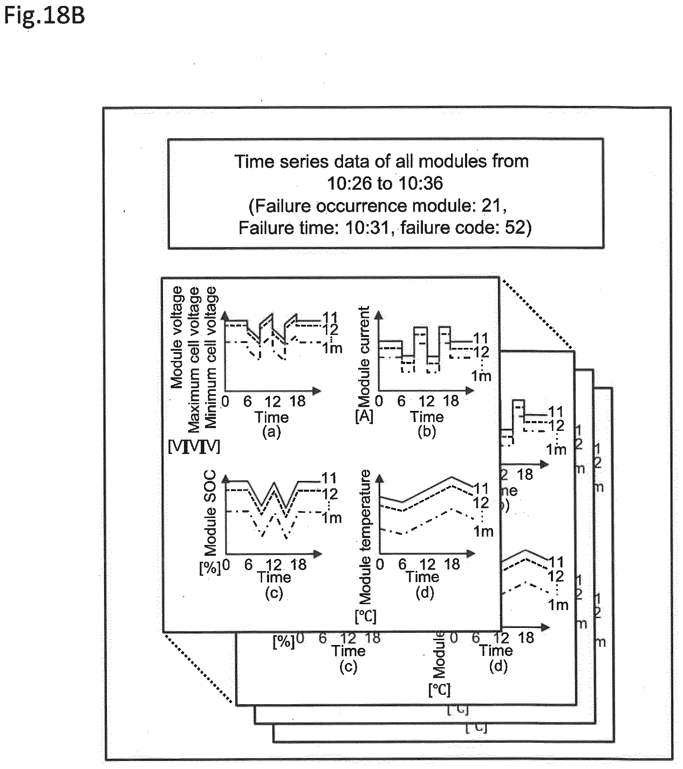

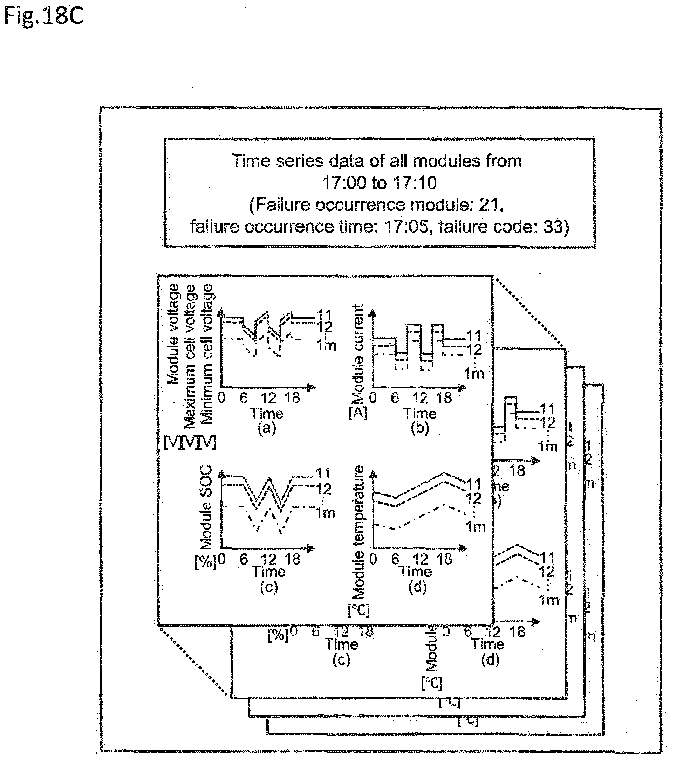

FIG. 18 is a diagram illustrating accumulated data in the ground server 8. in FIG. 16 by an example. The daily report data of FIG. 18 accumulates the failure occurrence time and the failure code of each battery module 3 in addition to the data of the first embodiment illustrated in FIGS. 4 and 9. Further, as the time series data, the time series data of the battery characteristic values of all the battery modules for several minutes before and after a failure occurrence accident is accumulated. That is, similarly to a drive recorder, the monitoring system 5 of the fifth embodiment continuously performs buffer storage, and uses the data only when the failure flag is input, that is, only the main points for several minutes before and after the accident as the time series data.

With the above configuration, the monitoring system 5 of the fifth embodiment can obtain the daily report data of the battery characteristic values of all the battery modules 3 and the time series data for several minutes before and after the failure occurs, and can analyze a failure factor in more detail from these pieces of information. Note that here, the acquisition target of the time series data is all the battery modules, but the present invention is not limited thereto. In the monitoring system 5 of the fifth embodiment, for example, only a battery module in which the failure has occurred may be set as the monitoring target by focusing on some battery modules. Other configurations of the monitoring system 5 of the fifth embodiment are the same as those of the first embodiment described above, and redundant descriptions are omitted.

Note that the present invention is not limited to the above-described embodiments, and includes various modifications. For example, the above-described embodiments have been described in detail for easy understanding of the present invention, and are not necessarily limited to those including all configurations described above. Further, a part of configuration of a certain embodiment can be replaced with a configuration of another embodiment, and a configuration of another embodiment can be added to a configuration of a certain embodiment. Furthermore, it is possible to add, delete, or replace another configuration for a part of configuration of each embodiment.

### [Supplement]

In recent years, on the background of environmental problems such as global warming, energy saving is considered to be more important in various industrial fields, and further reduction in power consumption is also required in the railway. In view of such a situation, rolling stocks equipped with a storage battery, such as a storage battery train that travels on a non-overhead line section only with storage battery electric power, and a hybrid diesel vehicle that combines an engine, and a storage battery, have become widespread.

An application target of the monitoring system 5 is a rolling stock equipped with the battery system 1, but a type thereof is not particularly limited. The monitoring system 5 can be applied to any rolling stock equipped with the battery system 1, in addition to the above-described train, the hybrid diesel vehicle, a train including a light load regeneration system that charges a storage battery with regenerative power and reuses the charged power, a train equipped with an emergency traveling system that travels with discharge power of a power storage device in an emergency, and the like.

Further, although a case where a lithium ion battery is applied as the storage battery constituting the battery system 1 has been assumed and-described, the present invention can be similarly applied to other power storage elements such as a lead battery and a nickel hydrogen battery. Note that the above-described LTE is an abbreviation of a current third generation mobile phone, but also means a communication standard called 3. 9G or 4G that is a long-term evolution of the 3G. A communication speed and capacity of LTE are close to those of a base station line for home broadband mobile phones.

The monitoring system 5 can be summarized as follows.
[1] The monitoring system 5 illustrated in FIG. 1 is a system that monitors a plurality of storage batteries arranged in the nth column × mth row in FIG. 13, in which the system generates and records at least one of the maximum value, the minimum value, the average value,and the integrated value of the battery characteristic values for one day in all the storage batteries as the daily report data, and transmits the daily report data to the server 8. Use of the daily report data is to identify where the battery cell is arranged in the nth column × mth row in order to mainly determine a maintenance timing, and then to obtain an index indicating the degradation level (life) as simply as possible.

Since the operation of the rolling stock is managed on a daily basis, the daily time series data and the daily report data are repeated in substantially the same pattern. That is, in the daily report data of the battery characteristic values for monitoring the storage batteries constituting the battery system 1 of the rolling stock, if variation factors such as a change in transportation demand due to social situations in addition to calendar and season and an environmental change such as weather are excluded, since the trains are operated according to the same schedule every day, the battery characteristic values are also repeatedly varied in the same pattern.

For example, in the case of the battery system 1 of the rolling stock that runs on time according to a schedule with full passengers on board during morning and evening Congestion on weekdays, the daily report data from Monday to Friday is often repeated in the same pattern. Therefore, if there is a change in the daily report data that deviates from the same pattern even though there is no variation factor described above, it is conceivable that it is caused by a failure or an accident. As described above, regarding the daily report data, only remarkable characteristic data among a huge amount of time series data can be shown with a small amount of information as illustrated in comparison in FIG. 9.

The monitoring system 5 can perform the life estimation, the predictive diagnosis, the factor analysis at the time of failure, and the like from the daily report data by calculating various index values for monitoring the storage battery by a statistical method. Therefore, an object of the monitoring system 5 is to issue appropriate information for long-term support of train 'operation management in addition to maintenance of the storage battery mounted on the rolling stock even if there is no real-time property to instruct the driver who is driving the rolling stock point by point. Depending on this purpose, for example, regarding the battery module 3 illustrated in FIG. 1, whether a monitoring range is set in units of the battery module 3 or individually set for each battery cell can be arbitrarily,set.

In order to achieve the object, the monitoring system 5 only needs to mainly deal with the daily report data obtained by extracting only the minimum necessary characteristic information from the enormous time series data. That is, if there is a change in the characteristic daily report data deviating from the same pattern described above, it is conceivable that it is caused by a failure or an accident, and thus it is sufficient to extract only the characteristic daily report data from the enormous time series data and efficiently monitor it.

Therefore, the monitoring system 5 that monitors the plurality of storage batteries generates at least one of the maximum value, the minimum value, the average value, and the integrated value of the battery characteristic values for one day in all the storage batteries as the daily report data, and records and outputs the daily report data, thereby reducing the amount of data as compared with the time series data patterned for each day. As a result, the monitoring system 5 of [1] can easily acquire data that can be used for the life estimation, the predictive diagnosis, the factor analysis at the time of failure, and the like while reducing the communication amount from the rolling stock to the ground server 8.

[2] In the monitoring system 5 of the above [1], it is preferable to generate and record the time series data of the battery characteristic values for one day in some storage batteries, and to transmit the time series data of some storage batteries to a ground server 8 together with daily report data of all the storage batteries. The monitoring system 5 can arbitrarily set the range, the information density, and the frequency of the monitoring target, and can monitor any one of the battery cells individually or simultaneously across the plurality of storage battery boxes 2. Therefore, simple daily report data and the enormous time series data can be appropriately used.

When the failure occurs, since the time series data at the optimum timing is provided in the easily analyzable state for investigating the cause of the failure, the amount of information is enormous, and the communication is also burdened. In contrast, regarding the daily report data, as illustrated in a comparison list in FIG. 9, only remarkable characteristic data among a huge amount of time series data can be shown with a small amount of information. As a result, the present monitoring system 5 of [2] can appropriately reduce the communication amount and thus can efficiently perform monitoring.

[3] In the monitoring system 5 of the above [2], the target storage battery from which the time series data is acquired is preferably switched every day as illustrated in FIGS. 11 and 13. According to this, it may be desirable to set a monitoring frequency to about once every several days depending on a monitoring purpose, and thus it is possible to perform monitoring by optimum setting according to the monitoring purpose. As a result, the monitoring system 5 of [3] can appropriately reduce the communication amount and thus can efficiently perform monitoring.

[4] In the monitoring system 5 of the above [3], the target storage battery to be switched every day is preferably set for each series group. That is, as illustrated in FIGS. 10 and 11, when each of the first to nth storage battery boxes 2 of the same standard includes the series group, and the first to nth storage battery boxes 2 are switched as the monitoring target every day, the monitoring system 5 of [4] can monitor the storage battery boxes 2 in units at an appropriate cycle according to a degradation rate . Further, in the monitoring system 5 of [4], when the unit of the storage battery box 2 to be switched as the monitoring target coincides with a unit to be replaced in maintenance, usability is further improved.

[5] In the monitoring system 5 of the above [3], the same number of target storage batteries to be switched every day may be selected from all series groups. That is, as illustrated in FIGS. 12 and 13, in the monitoring system 5, it is assumed that each of the storage battery boxes 2 of the same standard includes the series group, and the battery cells constituting the series group also have the same standard. In this case, when switching is performed every day so as to select the same number of battery cells from each series group of all the storage battery boxes 2 to be monitored, the current variation and the like between the series groups can be detected. As a result, the monitoring system 5 of [5] can monitor the degradation level in units of the battery cells corresponding to the number of selected battery cells at an appropriate cycle. Further, when the unit of the battery cell to be switched as the monitoring target coincides with the unit to be replaced in maintenance, the usability is further improved.

[6] In the monitoring system 5 of the above [1] to [5], the battery characteristic value of the storage battery is preferably indicated by any one or more of the current, the voltage, the temperature, and a charging rate as illustrated in FIG. 4. According to the monitoring system 5 of [6], for example, it is possible to set an appropriate allowable current value for charging and discharging according to a use state on the basis of a specification according to a type of the lithium ion battery and other storage batteries, and also to realize good management of a maintenance cycle.

[7] In the monitoring system 5 of the above [1] to [6], as illustrated in FIG. 8, the daily report data may be transmitted to the ground server 8 when the battery monitoring system 5 ends (shuts down). A normal computer device includes a cache memory and a main memory for memory calculation, such as a random access memory (RAM) used during operation, in which the data can be recorded only during energization, and a nonvolatile memory capable of holding stored contents even when the power supply is turned, off during non-operation. According to the monitoring system 5 of [7], since it is not necessary to store data between shutdown and restart, capacity required as the nonvolatile memory can be reduced in the upper controller 6 included in the onboard device.

[8] In the monitoring system 5 of the above [1] to [6], as illustrated in FIG. 14, the daily report data may be transmitted to the ground server 8 when the battery monitoring system 5 is first started every day. When one train is stopped many times a day for a long time due to train operation schedule, there is an operation in which the entire train including an auxiliary machine is put into a dormant state, for example, by lowering a pantograph. In such a case, the computer of the onboard device is shut down even in a daytime. At this time, it is convenient that the computer intermittently stores the daily report data for one day in a nonvolatile memory provided in the computer so as not to delete the data, and transmits the daily report data to the ground server 8 once only at the time of the first start every day.

As described above, in the monitoring system 5 of [8], the daily report data for one day stored intermittently for a plurality of times is collected into one. Therefore, in the monitoring system 5 of [8], any of the maximum value, the minimum value, the average value, and the integrated value of the battery characteristic values for one day in all the storage batteries is generated and transmitted by a processing or by a series of simple processing. As a result, the computer of the onboard device has less burden. Further, since the amount of data is small even for one day in the case of the daily report data, a small capacity of the nonvolatile memory required for the computer is sufficient according to the monitoring system 5 of [8].

[9] In the monitoring system 5 of the above [1] to [8], as illustrated in FIG. 18, the time series data of the battery characteristic values before and after occurrence of a storage battery failure may be generated and recorded, and may be transmitted to the ground server together with the daily report data of all the storage batteries. Such a monitoring system 5 can exhibits a function equivalent to that of a drive recorder suitable for investigating a cause of an automobile accident is exhibited, and can analyze the failure factor in more detail. That is, the monitoring system 5 of [9] continuously stores the time series data having a huge amount of information and imposing a burden on communication in the memory, and continues overwriting a storage area in the memory after a predetermined time, so that the time series can be used to investigate a failure cause even if capacity of the memory is small.

[10] The rolling stock onboard device (The onboard device suggested in FIG. 1) according to the embodiment of the present invention has a function of monitoring the plurality of storage batteries, generates and records at least one of the maximum value, the minimum value, the average value, and the integrated value of the battery characteristic values for one day in all the storage batteries as the daily report data, and transmits the daily report data to the ground server 8. Such an onboard device of [10] can easily output data that can be used for the life estimation, the predictive diagnosis, the factor analysis at the time of failure, and the like while reducing the communication amount from the rolling stock to the ground server 8.

[11] A. rolling stock storage battery monitoring method (the present method) according to the embodiment of the present invention is a method for monitoring the plurality of storage batteries in the rolling stock, the method generating and recording at least one of the maximum value, the minimum value, the average value, and the integrated value of the battery characteristic values for one day in all the storage batteries as the daily report data, and transmitting the daily report data to the ground server 8. In the present method, in a computer constituting the monitoring system 5, each function constituting the present monitoring system 5 is formed by a central processing unit (CPU) executing a program stored in a memory, and is executed by a predetermined procedure. The computer is preferably a one-chip microcomputer, but a part of a computer for other purposes may also be used. According, to the present method of [11] as described above, it is possible to easily acquire data that can be used for the life estimation, the predictive diagnosis, the factor analysis at the time of failure, and the like while reducing the communication amount from the rolling stock to the ground server 8.

### Reference Signs List

1 battery system
11 to 1m, 21 to 2m, n1 to nm battery module information
2 battery box
3 battery module
4 battery controller
4a battery characteristic value measuring part
4b SOC estimation part
4c abnormality diagnosis part
4d cell information processing part
5 battery monitoring system
6, 6' upper controller
6a, 6a' daily report data generator
6a1 maximum value calculator
6a2 minimum value calculator
6a3 average value calculator
6a4 integrated value calculator
6b, 6b", 6b'' time series data generator
6b1, 6b1', 6b1" time series data target extraction part
6b2 battery characteristic value data extraction part
6b3 module information rearrangement part
6c event data generator
7, 7' remote monitoring device
7a on-board server
7a1 start/end judgment part
7a2, 7a2' transmission data management part
7b router
7c antenna
8 ground server

## Claims

1. A rolling stock battery monitoring system that monitors a plurality of storage batteries, wherein the system generates and records at least one of a maximum value, a minimum value, an average value, and an integrated value of battery characteristic values for one day in all storage batteries as daily report data, and transmits the daily report data to a server.

2. The rolling stock battery monitoring system according to claim 1, wherein the system generates and records time series data of battery characteristic values for one day in some storage batteries, and transmits the time series data of the some storage batteries to a ground server together with daily report data of all the storage batteries.

3. The rolling stock battery monitoring system according to claim 2, wherein a target storage battery from which the time series data is acquired is switched every day.

4. The rolling stock battery monitoring system according to claim 3, wherein the target storage battery to be switched every day is set for each series group.

5. The rolling stock battery monitoring system according to claim 3, wherein a same number of target storage batteries to be switched every day are selected from all series groups.

6. The rolling stock battery monitoring system according to any one of claims 1 to 5, wherein a battery characteristic value of the storage battery is indicated by any one or more of a current, a voltage, a temperature, and a charging rate.

7. The rolling stock battery monitoring system according to any one of claims 1 to 6, wherein the daily report data is transmitted to a ground server when the battery monitoring system ends.

8. The rolling stock battery monitoring system according to any one of claims 1 to 6, wherein the daily report data is transmitted to a ground server when the battery monitoring system is first started every day.

9. The rolling stock battery monitoring system according to any one of claims 1 to 8, wherein time series data of battery characteristic values before and after occurrence of a storage battery failure is generated and recorded, and is transmitted to a ground server together with the daily report data of all the storage batteries.

10. A rolling stock onboard device that monitors a plurality of storage batteries, wherein the onboard device generates and records at least one of a maximum value, a minimum value, an average value, and an integrated value of battery characteristic values for one day in all storage batteries as daily report data, and transmits the daily report data to a ground server.

11. A rolling stock storage battery monitoring method for monitoring a plurality of storage batteries in a rolling stock, the method comprising:
generating and recording at least one of a maximum value, a minimum value, an average value, and an integrated value of battery characteristic values for one day in all storage batteries as daily report data; and
transmitting the daily report data to a ground server.
